# EUROPÄISCHE PATENTSCHRIFT

(11) **EP 0 816 859 B1**
(45) Veröffentlichungstag und Bekanntmachung des Hinweises auf die Patenterteilung: **02.11.2005**
(21) Anmeldenummer: 97110739.6
(22) Anmeldetag: 01.07.1997
(51) Int. Cl.: G01R 29/10, H01Q 1/12

(54) **Diagnoseverfahren und Diagnose-system für Kfz-Antennenscheiben**
Process and system for the diagnosis of car antennas
Procédé et système pour le diagnostique d'antennes d'automobile

(30) Priorität: 06.07.1996 DE 19627391
(43) Veröffentlichungstag der Anmeldung: 07.01.1998
(73) Patentinhaber: PILKINGTON Automotive Deutschland GmbH, 58455 Witten (DE)
(72) Erfinder: Paulus, Peter, Dr., 48167 Münster (DE)
(74) Vertreter: Niemann, Uwe

(56) Entgegenhaltungen:
- GB-A- 2 272 604
- US-A- 4 276 509
- PATENT ABSTRACTS OF JAPAN vol. 012, no. 007 (E-571), 9. Januar 1988 & JP 62 165444 A (NEC CORP), 22. Juli 1987

## Beschreibung

Die Erfindung betrifft ein Diagnoseverfahren für Kfz-Antennenscheiben mit mehreren Antennen, wobei zu Diagnosezwecken die Antennen mittels einer Sendeantenne mit einem Testsignal beaufschlagt werden sowie die sich dabei einstellenden Antennensignale ausgewertet werden und das Testsignal mit Hilfe einer in die Antennenscheibe integrierten Sendeantanne erzeugt wird. Die Erfindung betrifft insbesondere ein Diagnoseverfahren für solche Kfz-Antennenscheiben, bei denen die Antennen Bestandteile eines Diversitysystems sind, bei dem von einem Diversity-Prozessor je-wells eine Antenne ausgewählt und mit dem Empfänger verbunden wird. Sie betrifft auch ein Diagnosesystem zur Durchführung des Diagnoseverf ahrens.

Moderne Antennenscheiben weisen häufig zumindest eine AM-Antenne und eine oder mehrere Radio- und TV-Antennen auf. Zunehmend verbreitet sind dabei Diversitysysteme, bei denen auf einer Antennenscheibe mehrere Antennen für denselben Frequenzbereich vorhanden sind. Im Diversity-Betrieb wählt ein Diversity-Prozessor diejenige Antenne aus, die die günstigsten Empfangs eigenschaften aufweist, und verbindet diese mit dem Empfänger. Bei derart komplexen Antennensystemen können eine Vielzahl von Störungen auftreten. Dabei kann es sich um Defekte der die Antennen bildenden Antennenleiter, Defekte der Verbindungen Antenne/Verstärker, Defekte des Verstärkers, Defekte des Diversity-Prozessors und um Defekte der Verbindung zum Empfänger handeln. Um eine eindeutige Ortung dieser Fehlerquellen zu ermöglichen, sind Diagnoseverfahren bekannt.

Bein einem Diagnoseverfahren der eingangs beschriebenen Gattung (US A 4 276 509) werden die Antennen der Antennenscheibe mit einem Signalgenerator verbunden und werden die daraufhin von den Antennen abgegebenen Testsignale mit einem außen über die Antennenscheibe geführten Meßgerät erfaßt.

Bei einem aus der Praxis bekannten Diagnoseverfahren, mit dem Defekte der Artennenleiter in der eingebauten Kfz-Antennenscheibe ermittelt worden können, wird eine Sendeantenne in der Nähe des Kraftfahrzeugs angeordnet oder außen an diesem angebracht und wird dieser Sendeantenne ein Testsignal aufgegeben. Die sich dadurch in den einzelnen Antennen der Antennenscheibe einstellenden Antennensignale werden mit Hilfe einer Diagnoseanordnung erfaßt und ausgewertet eine zuverlässige und reproduzierbare Diagnose ist aber nur dann möglich, wenn die Sendeantenne sich stets exakt und reproduzierbar in einer vorgegebenen räumlichen Positionierung relativ zur Antennenscheibe befindet und wenn darüber hinaus Störsignale weitestgehend ausgeschlossen werden können. Die Bereitstellung entsprechender Räumlichkeiten und geeigneter Sendeantennen und Diagnosegeräten dürfte insbesondere kleineren Kf z-Werkstätten im Regelfall schwerfallen. Daneben ist es auch be kannt, mit einem Widerstandsmeßgerät den elektrischen Durchgang eines An tennenleiters bis zum Verstärkereingang zu erfassen. Das setzt voraus, daß Anfang und Ende des Antenne n-leiters zugänglich sind.

Aufgabe der Erfindung ist es, die Diagnose von Kfz-Antennenscheiben, in s-besondere von für den Diversity-Betrieb eingerichteten Antennenscheiben, mit geringem apparativem Aufwand, schnell und zuverlässig zu ermöglichen.

Diese Aufgabe wird dadurch gelöst, daß die sich aufgrund dieses Testsignals In den anderen Antennen der Antennenscheibe einstellenden An - tennensignale ausgewertet werden. Bei für den Diversity-Betrieb eingerich - teten Kfz-Antennenscheiben mit einem einen Diversity-Prozessor aufweise n-den Diversity-System wird das Testsignal bevorzugt mit einem dem Diversity-Prozessor zugeordneten Signalgenerator erzeugt, denn im Bereich eines Diversity-Prozessors befinden sich bereits digitale und/oder analoge Schaltkreise, die das Umschalten der Antennen, aber auch das Erkennen eines Diagnosemodus, übernehmen können. In diese Schaltung kann ohne großen Aufwand ein Signalgenerator integriert werden.

Das Testsignal sollte vorzugsweise einer von den übrigen Antennen galva - nisch getrennten Sendeantenne aufgegeben werden. Für die Auswahl und Auslegung der Sendeantenne gibt es eine Reihe von Möglichkeiten: Das Testsignal beispielsweise einem für die Diagnose als Sendeantenne dienenden Heizfeld der Antennenscheibe aufgegeben werden, sofern ein solches vorhanden ist. Eine andere Möglichkeit besteht darin, eine oder gegebenenfalls mehrere der im Normalbetrieb dem Empfang von Radio- oder TV-Wellen dienenden Antennen für die Diagnose als Sendeantenne einzusetzen. In diesem Falle läßt das Auftreten eines ausreichend hohen Signalpegels in mindestens einer der anderen Antennen auch den Schluß zu, daß die Sendeantenne fehlerfrei ist, so daß gleichzeitig mit der Diagnose der übrigen Antennen eine Eigendiagnose der Sendeantenne erfolgt.

Eine Optimierung des Diagnoseverfahrens kann dann besonders gut gelingen, wenn die Sendeantenne von einer ausschließlich für Diagnosezwecke vorhandenen und ausgelegten Hilfsantenne gebildet wird, die also nicht zum Radio- oder TV-Empfang benutzt wird. Diese Hilfsantenne sollte vorzugsweise so angeordnet und konfiguriert werden, daß das von ihr ausgesandte Testsignal von allen zu prüfenden Antennen in etwa gleich gut empfangen wird. Eine andere und besonders bevorzugte Möglichkeit besteht darin, einen gegebenenfalls vorhandenen AM-Leiter als Sendeantenne zum Prüfen der Radio- oder TV-Antennen und damit gleichzeitig zur Eigenprüfung zu verwenden.

Es ist grundsätzlich möglich und wünschenswert, das Testsignal möglichst genau auf die Frequenzbereiche der zu prüfenden Antennen abzustimmen. Die Frequenz des Testsignals kann durch einen Quarz, den Empfänger oder einen Rechner vorgegeben und das Testsignal mittels einer Zwischenfrequenzleitung oder anderer Steuer- oder sonstiger Leitungen zur Sendeantenne übermittelt werden. Wird das so erzeugte Testsignal der in die Antennenscheibe integrierten Sendeantenne aufgegeben, dann wird wegen der starken Verkoppelung der Antennen untereinander in den anderen Antennen ein definiertes Signal erzeugt, das vom Empfänger, gegebenenfalls zusammen mit dem Diversity-Prozessor, im Diagnosemodus nach Frequenzband und Antenne separat ausgewertet werden kann. Bei einer aus wirtschaftlichen Erwägungen bevorzugten Ausführung der Erfindung ist das Testsignal ein Rechtecksignal. Ein steilflankiges Rechtecksignal, das beispielsweise eine Frequenz von etwa 1 MHz aufweisen kann, hat Oberwellen, die bis in den UHF-Bereich reichen, und eignet sich somit als ohne großen Aufwand erzeugbares Testsignal für die Mehrzahl der üblichen Radio- und TV-Frequenzbereiche.

Zwar ist die Erfindung vorliegend in der Anwendung auf Kfz-Antennenscheiben mit Radio- und TV-Antennen beschrieben. Es versteht sich jedoch, daß auch andere Antennen, z.B. GPS-Antennen, Mobilfunkantennen etc. mit dem erfindungsgemäßen Diagnoseverfahren überprüfbar sind.

Gegenstand der Erfindung ist auch ein Diagnosesystem zur Durchführung des Verfahrens bei mindestens einer Antennenscheibe mit mehreren für den Diversity-Betrieb eingerichteten Antennen, mit einem Diversity-Prozessor und davon gesteuerten Schaltern zwischen den Antennen und mit zumindest einem Empfänger, wobei das Diagnosesystem gekennzeichnet ist durch eine in die Antennenscheibe integrierte Sendeantenne, die mit einem dem Diversity-Prozessor zugeordneten Signalgenerator zur Erzeugung des Testsignals verbindbar ist. Die Sendeantenne kann eine von den übrigen Antennenleitem galvanisch getrennte Antenne, insbesondere eine AM-Antenne, ein Heizfeld oder eine der im Normalbetrieb dem Empfang der Radio- oder TV-Wellen dienenden Antennen der Antennenscheibe sein.

Eine bevorzugte Ausführung ist gekennzeichnet durch eine Steuerlogik, die aufgrund eines vom Empfänger abgegebenen Steuersignals den Signalgenerator einschaltet und nacheinander die vom Empfänger oder vom Diversity-Prozessor vorgegebenen Antennen auswählt. Zur Auswertung kann ein mit dem Empfänger oder mit dem Diversity-Prozessor verbindbarer Diagnose-Computer vorgesehen werden.

Dieses Diagnosesystem ist eigendiagnosefähig und ermöglicht bei einfacher Handhabung einen automatisierten Diagnoseablauf.

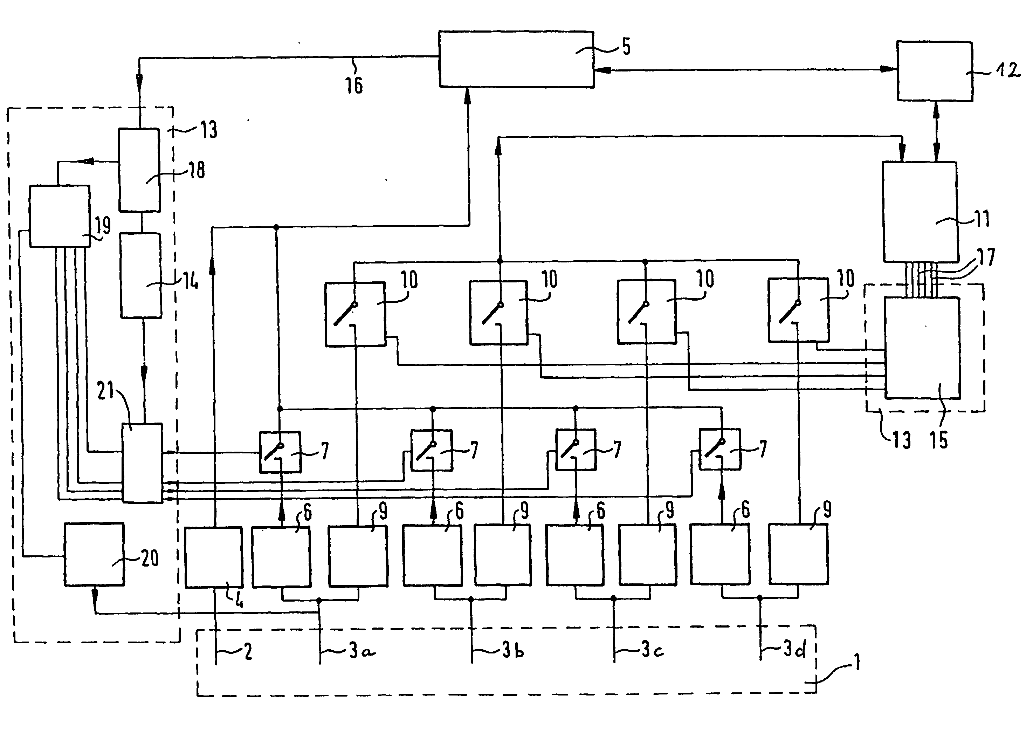

Im folgenden wird ein in der Zeichnung dargestelltes Ausführungsbeispiel der Erfindung erläutert; die einzige Figur zeigt schematisch ein Blockschaltbild eines Diagnosesystems für die Diagnose von Antennenleitern in Kfz-Antennenscheiben.

In der Zeichnung ist eine Kfz-Antennenscheibe 1 angedeutet, die eine AM-Antenne 2 und mehrere Antennen 3a-d für den Radio- und TV-Empfang im Diversity-Betrieb aufweist. Die AM-Antenne 2 ist über einen Antennenverstärker 4 mit einem Radio-Empfänger 5 verbunden. Die Antennen 3a-d sind für den Radioempfang über zugeordnete Verstärker 6 und nachgeordnete Schalter 7 ebenfalls mit dem Radio-Empfänger 5 verbunden. Für den TV-Empfang sind die Antennen 3a-d außerdem über zugeordnete TV-Verstärker 9 und nachgeordnete Schalter 10 mit dem TV-Empfänger 11 verbunden. Beide Empfänger 5, 11 sind an einen Diagnose-Computer 12 anschließbar.

Für den Radio- und TV-Empfang im Diversity-Betrieb ist mindestens ein Diversity-Prozessor 13 vorgesehen, der mit seinem Radio-Teil 14 die jeweils für den Radio-Empfang günstigste der Antennen 3a-d auswählt und dementsprechend die Schalter 7 steuert, so daß die ausgewählte der Antennen 3a-d mit dem Radio-Empfänger 5 verbunden wird, und der mit seinem TV-Teil 15 in entsprechender Weise die Schalter 10 steuert. Dazu ist der Radio-Teil 14 des Diversity-Prozessors 13 über zumindest eine Steuerleitung 16 mit dem Radio-Empfänger 5 verbunden und sein TV-Teil 15 über Steuerleitungen 17 mit dem TV-Empfänger 11.

Für Diagnosezwecke weist der Diversity-Prozessor 13 eine in der Steuerleitung 16 liegende Weiche 18 auf, die ein vom Radio-Empfänger 5 abgegebenes Diagnose-Steuersignal an eine Steuerlogik 19 weiterleitet, die einen Signalgenerator 20 startet, der mit einer der für den Diversity-Betrieb eingerichteten und im Diagnosemodus als Sendeantenne fungierenden Antenne 3a verbunden ist. Im dargestellten Fall ist die Sendeantenne im Normalbetrieb eine der Antennen 3a-d für den Empfang von Radio- oder TV-Wellen. Die Sendeantenne könnte aber auch durch die AM-Antenne 2 oder andere sendefähige Leiter in oder auf der Antennenscheibe 1 gebildet werden. Die Steuerlogik 19 steuert außerdem einen zwischen dem Radio-Teil 14 des Diversity-Prozessors 13 und den Schaltern 7 angeordneten Umschalter 21 zum wahlweisen Aktivieren des Normalbetriebmodus oder des Diagnosebetriebmodus.

Der Signalgenerator 20 liefert bei der dargestellten Ausführung ein steilflankiges Rechtecksignal mit einer Frequenz von 1 MHz, das Oberwellen bis in den UHF-Bereich besitzt. Dieses Rechtecksignal wird der als Sendeantenne dienenden Antenne 3a der Antennenscheibe 1 aufgegeben. Aufgrund der starken Verkoppelung der Antennenleiter 3a-d untereinander wird in den anderen Antennenleitem 3b-d sowie dem AM-Antennenleiter ein definiertes Signal mit Komponenten in allen Empfangsbereichen erzeugt, das von den Empfängern 5, 11 zusammen mit dem Diversity-Prozessor 13 im Diagnosemodus nach Frequenzband und Antenne separat getestet und im Diagnose-Computer 12 analysiert werden kann. Eine geprüfte Antenne ist dann als fehlerfrei zu bewerten, wenn der gemessene Pegel des Testsignals in dieser Antenne über einem vorgegebenen Schwellwert liegt.

Es versteht sich, daß je nach vorhandener und zu prüfender Antennen- und Gerätekonfiguration verschiedene Möglichkeiten der Realisierung der Erfindung bestehen. So könnte beispielsweise die Software des Diagnose-Computers 12 eine oder mehrere der Funktionen der Schalter 7 und 10 oder des Diversity-Prozessors 13 übernehmen. Auch könnte das Prüfen der AM-Antenne 2 mit Hilfe eines dem Diversity-Prozessor 13 zugeordneten Umschalters erfolgen, statt wie im Ausführungsbeispiel mittels eines im Empfänger 5 befindlichen Umschalters. Ebenfalls denkbar ist es, nacheinander oder gleichzeitig mit mehreren Sendeantennen in der Antennenscheibe zu arbeiten, um die Qualität der Diagnose weiter zu verbessern. Schließlich liegt es im Rahmen der Erfindung, bei Fahrzeugen mit mehreren Antennenscheiben eine zur erfindungsgemäßen Diagnose in eine dieser Antennenscheiben integrierte Sendeantenne nicht nur zur Diagnose der Antennen dieser Antennenscheibe, sondern bei ausreichender Verkopplung der Antennen untereinander auch zum Prüfen der Antennen der anderen Antennenscheiben zu verwenden.

## Patentansprüche

1. Diagnoseverfahren für Kfz-Antennenscheiben (1) mit mehreren Antennen (3a-3d), wobei zu Diagnosezwecken die Antennen (3a-3d) mittels einer Sendeantenne (2, 3a) mit einem Testsignal beaufschlagt werden sowie die sich dabei einstellenden Antennensignale ausgewertet werden und das Testsignal mit Hilfe einer in die Antennenscheibe (1) integrierten Sendeantenne (2, 3a) erzeugt wird, **dadurch gekennzeichnet, daß** die sich aufgrund dieses Testsignals in den anderen Antennen (3a-3d, 3b-3d) der Antennenscheibe (1) einstellenden Antennensignale ausgewertet werden.

2. Diagnoseverfahren nach Anspruch 1, wobei die Antennen (3a-3d) Bestandteile eines Diversity-Systems sind, bei dem von einem Diversity-Prozessor (13) jeweils eine Antenne (3a-3d) ausgewählt und mit dem Empfänger (5) verbunden wird, **dadurch gekennzeichnet, daß** das Testsignal mit einem dem Diversity-Prozessor (13) zugeordneten Signalgenerator (20) erzeugt wird.

3. Diagnoseverfahren nach Anspruch 1 oder 2, **dadurch gekennzeichnet, daß** das Testsignal einer von den anderen Antennen (3a-3d, 3b-3d) galvanisch getrennten Sendeantenne (2, 3a) aufgegeben wird.

4. Diagnoseverfahren nach einem der Ansprüche 1 bis 3, **dadurch gekennzeichnet, daß** das Testsignal einem als Sendeantenne dienenden Heizfeld aufgegeben wird.

5. Diagnoseverfahren nach einem der Ansprüche 1 bis 3, **dadurch gekennzeichnet, daß** das Testsignal einer ausschließlich für Diagnosezwecke vorgesehenen und ausgelegten Hilfsantenne aufgegeben wird.

6. Diagnoseverfahren nach einem der Ansprüche 1 bis 3, **dadurch gekennzeichnet, daß** das Testsignal einer im Normalbetrieb als Antenne zum Empfang von Radio- oder TV-Wellen dienenden Sendeantenne (2, 3a-3d) aufgegeben wird.

7. Diagnoseverfahren nach einem der Ansprüche 1 bis 3, **dadurch gekennzeichnet, daß** das Testsignal einer AM-Antenne (2) als Sendeantenne aufgegeben wird.

8. Diagnoseverfahren nach einem der Ansprüche 1 bis 7, **dadurch gekennzeichnet, daß** als Testsignal ein steilflankiges Rechtecksignal verwendet wird.

9. Diagnosesystem zur Durchführung des Verfahrens nach einem der Ansprüche 2 bis 8, **gekennzeichnet durch** mehrere für den Diversity-Betrieb eingerichtete Antennen (3a-3d), einen Diversity-Prozessor (13) und davon gesteuerte Schalter (7, 10) zwischen den Antennen (3a - 3d) und **durch** zumindest einen Empfänger (5, 11), und **durch** eine in die Antennenscheibe (1) integrierte Sendeantenne (2, 3a), die mit einem dem Diversity-Prozessor (13) zugeordneten Signalgenerator (20) verbindbar ist, und **durch** einen mit dem Empfänger (5, 11) oder mit dem Diversity-Prozessor (13) verbindbaren Diagnose-Computer (12) sowie **durch** eine Steuerlogik (20) zum Einschalten des Signalgenerators (20) aufgrund eines vom Empfänger (5. 11) abgegebenen Steuersignals und zum Verbinden des Signalgenerators (20) mit der. Sendeantenne (2, 3a) sowie zum Auswählen der vom Empfänger (5, 11) oder vom Diversity-Prozessor (13) vorgegebenen Antenne (3a-3d, 3b-3d) zur Diagnose.

## Claims

1. Diagnostic method for motor vehicle antenna panes (1) with several antennae (3a-3d), wherein for diagnostic purposes the antennae (3a-3d) are acted on with a test signal by means of a transmitting antenna (2, 3a) and the then resulting antenna signals are evaluated and the test signal is produced with the help of a transmitting antenna (2a, 3a) integrated in the antenna pane (1), **characterised in that** the antenna signals resulting in the other antenna (3a-3d, 3b-3d) of the antenna pane (1) by reason of this test signal are evaluated.

2. Diagnostic method according to claim 1, wherein the antenna (3a-3d) are components of a diversity system in which a respective antenna (3a-3d) is selected by a diversity processor (13) and connected with the receiver (5), **characterised in that** the test signal is produced by a signal generator (20) associated with the diversity processor (13).

3. Diagnostic method according to claim 1 or 2, **characterised in that** test signal is delivered to a transmitting antenna (2a, 3a) electrically separated from the other antennae (3a-3d, 3b-3d).

4. Diagnostic method according to one of claims 1 to 3, **characterised in that** the test signal is delivered to a heating field serving as transmitting antenna.

5. Diagnostic method according to one of claims 1 to 3, **characterised in that** the test signal is delivered to an auxiliary antenna provided and designed exclusively for diagnostic purposes.

6. Diagnostic method according to one of claims 1 to 3, **characterised in that** the test signal is delivered to a transmitting antenna (2, 3a-3d) serving in normal operation as an antenna for reception of radio or television waves.

7. Diagnostic method according to one of claims 1 to 3, **characterised in that** the test signal is delivered to an AM antenna (2) as transmitting antenna.

8. Diagnostic method according to one of claims 1 to 7, **characterised in that** a steep-flanked rectangular signal is used as test signal.

9. Diagnostic system for carrying out the method according to one of claims 2 to 8, **characterised by** several antenna (3a-3d) equipped for diversity operation, a diversity processor (13) and switches (7, 10), which are controlled by the processor, between the antennae (3a-3d) and by at least one receiver (5, 11) and by a transmitting antenna (2, 3a), which is integrated in the antenna pane (1) and is connectible with a signal generator (20) associated with the diversity processor (13) and by a diagnostic computer (12), which is connectible with the receiver (5, 11) or with the diversity processor (13) as well as by a control logic system (20) for switching on the signal generator (20) by reason of a control signal delivered by the receiver (5, 11) and for connecting the signal generator (20) with the transmitting antenna (2, 3a) as well as for selecting the antenna (3a-3d, 3b-3d), which is predetermined by the receiver (5, 11) or by the diversity processor (13), for diagnosis.

## Revendications

1. Procédé de diagnostic pour pare-brise à antennes (1) de véhicules automobiles comportant plusieurs antennes intégrées (3a-3d), sachant que lesdites antennes (3a-3d) sont sollicitées par un signal de test à des fins diagnostiques, au moyen d'une antenne émettrice (2, 3a), les signaux d'antennes s'instaurant étant alors interprétés, et le signal de test étant engendré à l'aide d'une antenne émettrice (2, 3a) intégrée dans le pare-brise (1), **caractérisé par** une interprétation des signaux d'antennes s'instaurant, suite à ce signal de test, dans les autres antennes (3a-3d, 3b-3d) du pare-brise (1) à antennes intégrées.

2. Procédé de diagnostic selon la revendication 1, les antennes (3a-3d) faisant partie intégrante d'un système diversifié dans lequel, sous l'action d'un processeur diversifié (13), une antenne respective (3a-3d) est sélectionnée et connectée au récepteur (5), **caractérisé par le fait que** le signal de test est engendré par un générateur de signaux (20) associé audit processeur diversifié (13).

3. Procédé de diagnostic selon la revendication 1 ou 2, **caractérisé par le fait que** le signal de test est appliqué à une antenne émettrice (2, 3a) séparée galvaniquement d'avec les autres antennes (3a-3d, 3b-3d).

4. Procédé de diagnostic selon l'une des revendications 1 à 3, **caractérisé par le fait que** le signal de test est appliqué à une zone chauffante servant d'antenne émettrice.

5. Procédé de diagnostic selon l'une des revendications 1 à 3, **caractérisé par le fait que** le signal de test est appliqué à une antenne auxiliaire prévue et agencée exclusivement à des fins diagnostiques.

6. Procédé de diagnostic selon l'une des revendications 1 à 3, **caractérisé par le fait que** le signal de test est appliqué à une antenne émettrice (2, 3a-3d) servant, en service normal, d'antenne de réception d'ondes radio ou TV.

7. Procédé de diagnostic selon l'une des revendications 1 à 3, **caractérisé par le fait que** le signal de test est appliqué à une antenne AM (2) agissant comme une antenne émettrice.

8. Procédé de diagnostic selon l'une des revendications 1 à 7, **caractérisé par le fait qu'**un signal rectangulaire à flancs à pente raide est utilisé en tant que signal de test.

9. Système de diagnostic pour la mise en oeuvre du procédé selon l'une des revendications 2 à 8, **caractérisé par** plusieurs antennes (3a-3d) agencées pour le mode diversifié ; par un processeur diversifié (13) et des interrupteurs (7, 10) commandés par ce dernier, entre les antennes (3a-3d) ; par au moins un récepteur (5, 11); par une antenne émettrice (2, 3a) incorporée dans le pare-brise (1) à antennes intégrées, et pouvant être raccordée à un générateur de signaux (20) associé au processeur diversifié (13) ; et par un ordinateur de diagnostics (12), pouvant être raccordé au récepteur (5,11) ou au processeur diversifié (13) ; ainsi que par une logique de commande (19) conçue pour enclencher le générateur de signaux (20) sur la base d'un signal de commande délivré par le récepteur (5, 11), pour raccorder ledit générateur de signaux (20) à l'antenne émettrice (2, 3a), ainsi que pour sélectionner, en vue du diagnostic, l'antenne (3a-3d, 3b-3d) préétablie par l'émetteur (5, 11) ou par le processeur diversifié (13).
